# EUROPÄISCHE PATENTSCHRIFT

(11) **EP 0 762 496 B1**
(45) Veröffentlichungstag und Bekanntmachung des Hinweises auf die Patenterteilung: **13.07.2005**
(21) Anmeldenummer: 96810501.5
(22) Anmeldetag: 26.07.1996
(51) Int. Cl.: H01L 23/49, H01L 23/48, H01L 25/07

(54) **Leistungshalbleitermodul**
Semiconductor power module
Module semi-conducteur de puissance

(30) Priorität: 17.08.1995 DE 19530264
(43) Veröffentlichungstag der Anmeldung: 12.03.1997
(73) Patentinhaber: ABB RESEARCH LTD., 8050 Zürich (CH)
(72) Erfinder: Faller, Kurt, 5200 Brugg (CH); Frey, Toni, Dr., La Jolla, CA 92037 (US); Keser, Helmut, 5408 Ennetbaden (CH); Steinruck, Ferdinand, 6295 Mosen (CH); Zehringer, Raymond, Dr., 5444 Künten (CH)
(74) Vertreter: ABB Patent Attorneys

(56) Entgegenhaltungen:
- EP-A- 0 158 749
- US-A- 5 098 305
- US-A- 5 221 851
- PATENT ABSTRACTS OF JAPAN vol. 014, no. 133 (E-0902), 13. März 1990 & JP 02 001959 A (NEC CORP), 8. Januar 1990
- "BIMETAL VLSI CHIP INTERCONNECTIONS" IBM TECHNICAL DISCLOSURE BULLETIN, Bd. 29, Nr. 11, April 1987, Seite 5021/5022 XP002040446

## Beschreibung

### Technisches Gebiet

Die Erfindung bezieht sich auf das Gebiet der Leistungselektronik. Sie geht aus von einem Leistungshalbleitermodul nach dem Oberbegriff des ersten Anspruchs.

### Stand der Technik

Ein solches Leistungshalbleitermodul wird schon im US Patent mit der Nummer 5,221,851 beschrieben. Es handelt sich dabei um sogenanntes Druckkontakt-Halbleitermodul, bei welchem mehrere Halbleiterchips mit ihrer ersten Hauptelektrode auf einer Grundplatte aufgebracht sind. Die zweiten Hauptelektroden der Chips werden von einer Mehrzahl von Kontaktstempeln kontaktiert. Die Grundplatte ist mit einem ersten Hauptanschluss und die Kontaktstempel sind mit einem zweiten Hauptanschluss verbunden. Die Hauptanschlüsse können scheibenförmig ausgebildet sein und mittels Flanschen zusammengehalten werden. Der Druckkontakt ist also in Form eines Kupferstempels ausgebildet, welcher auf die einzelnen Chips drückt.

Problematisch bei dieser Anordnung sind jedoch die Anforderung an die Planparallelität der Chipoberflächen bzw. der Kupferstempel. Die für einen Druckkontakt benötigte Planparallelität beträgt beispielsweise bei einer kreisrunden Scheibe mit einem Durchmesser von 7 cm nur wenige Mikrometer. Diese Anforderung bei einer Anordnung mit einer Mehrzahl von Chips einzuhalten ist sehr schwierig, da die einzelnen Chips mit konventioneller Löttechnik praktisch kaum auf einer gemeinsamen Höhe geschweige den planparallel gelötet werden können.

### Darstellung der Erfindung

Aufgabe der vorliegenden Erfindung ist es deshalb, ein Leistungshalbleitermodul anzugeben, bei welchem weniger hohe Anforderungen an die Planparallelität gestellt werden.

Diese Aufgabe wird bei einem Leistungshalbleitermodul der eingangs genannten Art durch die Merkmale des ersten Anspruchs gelöst.

Kern der Erfindung ist es also, dass die Lage jedes Kontaktstempels entsprechend dem Abstand von jedem Halbleiterchip zum zweiten Hauptanschluss individuell eingestellt werden kann. Da die Lage der Kontaktstempel für jeden Halbleiterchip individuell eingestellt werden kann, spielt die Planparallelität keine derart grosse Rolle mehr.

Die Kontaktstempel sind beweglich gelagert. Zur Einstellung der Position sind dafür ausgebildete Mittel vorgesehen. Diese können beispielsweise eine Lotschicht oder eine Feder mit allfälligen Gleitkontakten umfassen. Die Lotschicht umgibt den Kontaktstempel in dafür vorgesehenen Bohrungen und dient sowohl der mechanischen Fixierung der Kontaktstempel als auch der elektrischen Kontaktierung. Bei der Variante mit den Federn sind diese in den Bohrungen angeordnet, welche für die Aufnahme der Kontaktstempel vorgesehen sind. Zur Verbesserung des elektrischen Kontaktes können ausserdem ein Gleitkontakt, z.B. in Form einer Gleitfeder mit einer Vielzahl von Einzellamellen aus elektrisch gut leitendem Material, entlang der Seitenwände der Bohrungen vorgesehen werden.

Halbleitermodule, bei welchen die Kontaktstempel mittels Lötung fixiert werden, werden am besten so hergestellt, dass zunächst die Halbleiterchips auf die Grundplatte aufgelötet werden. Anschliessend wird die Grundplatte mit den Halbleiterchips in den mit mindestens einer Bohrung und mit mindestens einem Kontaktstempel und dazwischen gefügter Lotschicht bestückten zweiten Hauptanschluss eingesetzt. Die Lage der Grundplatte zum zweiten Hauptanschluss wird nun fixiert, und das Halbleitermodul mit nach oben weisendem zweiten Hauptanschluss in einem Lötofen verlötet. Dabei schmilzt die Lotschicht zwischen dem Kontaktstempel und dem zweiten Hauptanschluss und fixiert die individuelle Position der Kontaktstempel. Diese wurde aufgrund der Schwerkraft vor dem Lötvorgang automatisch eingestellt.

Der Vorteil der Erfindung liegt also darin, dass keine derart hohen Anforderungen an die Planparallelität mehr notwendig sind. Dies erlaubt insbesondere eine kostengünstige Herstellung der Module. Ausserdem gewährleistet die Kontaktierung der Chips mittels Kontaktbolzen, seien diese angelötet oder mittels Federn mit Druck beaufschlagt, für einen permanenten und individuellen Druck auf jeden einzelnen Chip. Insbesondere im Falle, dass das Modul oder Teile davon im Falle eines Fehlers aufschmelzen, wird dadurch ein permanenter niederohmige Übergangswiderstand zwischen den Gehäusekontakten und dem Chip erreicht. Beim Stand der Technik schmelzen die Bonddrähte durch. Dies kann zu einer vollständigen Zerstörung des Bauelements führen. Somit bietet die erfindungsgemässe Art der Kontaktierung zusätzlich den Vorteil, dass bei Ausfall eines der intern parallelgeschalteten Chips der ganze Nominal- aber auch der Kurzschlussstrom niederohmig über den defekten Chip geleitet werden kann.

Weitere Ausführungsbeispiele ergeben sich aus den entsprechenden abhängigen Ansprüchen.

### Kurze Beschreibung der Zeichnungen

Nachfolgend wird die Erfindung anhand von Ausführungsbeispielen im Zusammenhang mit den Zeichnungen näher erläutert.

Es zeigen:
- **Fig. 1**: Einen Schnitt durch ein erfindungsgemässes Leistungshalbleitermodul nach einer ersten Ausführungsform; und
- **Fig. 2**: Einen Schnitt durch ein erfindungsgemässes Leistungshalbleitermodul nach einer zweiten Ausführungsform.

Die in den Zeichnungen verwendeten Bezugszeichen und deren Bedeutung sind in der Bezeichnungsliste zusammengefasst aufgelistet. Grundsätzlich sind in den Figuren gleiche Teile mit gleichen Bezugszeichen versehen.

### Wege zur Ausführung der Erfindung

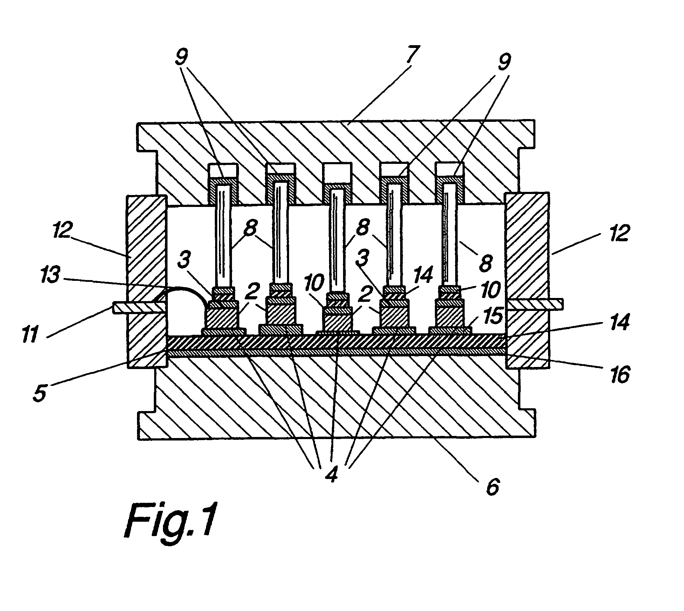

Figur 1 zeigt ein erstes Beispiel, wie die Erfindung realisiert werden kann. Mit 1 ist ein Leistungshalbleitermodul bezeichnet, welches einen ersten und einen zweiten Hauptanschluss 6, 7 aufweist. Die Hauptanschlüsse 6,7 können aus einem massiven Kupferblock bestehen. Auf den ersten Hauptanschluss 6 ist eine Grundplatte 5 aufgebracht. Dies kann beispielsweise eine Molybdänplatte 14, eine Keramikplatte oder ein Platte aus anderen geeigneten Materialien sein, welche mit einer Lotschicht 16 auf dem ersten Hauptanschluss 6 befestigt ist. Der Querschnitt der Grundplatte ist für die Erfindung nicht von Bedeutung. Er kann rund oder eckig sein. Auf die Grundplatte 5 sind mehrere Halbleiterchips 2 aufgelötet. Vorzugsweise handelt es sich bei den Halbleiterchips um IGBT-Chips oder um Diodenchips oder um eine Kombination dieser Arten von Chips. Grundsätzlich weisen die Chips 2 jedoch mindestens zwei Hauptelektroden 3 und 4 auf, welche von den entsprechenden Hauptanschlüssen 6 und 7 kontaktiert werden. Im Falle von IGBT-Chips ist noch eine dritte Elektrode, eine Steuerelektrode vorgesehen, welche über einen Anschlussdraht 13 mit einem Steueranschluss 11 verbunden ist. Der Anschlussdraht 13 wird z.B. auf die Steuerelektrode des Chips 2 gebondet. Die eine Hauptelektrode 4 wird durch die Unterseite des Chips 2 gebildet und steht in direkter Verbindung mit der Grundplatte 5.

Die andere Hauptelektrode 3 der Halbleiterchips 2 wird von einer der Anzahl Chips entsprechenden Anzahl von Kontaktstempeln 8 kontaktiert. Wie eingangs bereits erläutert wurde, besteht ein Problem bei den Leistungshalbleitermodulen darin, dass es Schwierigkeiten bereitet, die Chips 2 auf dieselbe Höhe anzulöten. Der hohe Grad an Planparallelität ist jedoch für einen problemlosen Druckkontakt notwendig. Um die Problematik deutlich zu machen, sind in Figur 1 die unterschiedlich dicken Lötschichten 15 überzeichnet dargestellt. Auch im Falle von unterschiedlich dicken Chips, z.B. bei einer Kombination von verschiedenen Chiptypen, ergibt sich eine unterschiedliche Höhe der Stapel bestehend aus Lötschichten, allenfalls dazwischen gefügten Molybdänscheiben und Halbleiterchips. Mit der Erfindung gelingt es nun, ein Leistungshalbleitermodul zu bauen, bei welchem diese Unterschied keinen Nachteil mehr darstellen.

Dies wird dadurch erreicht, dass die Kontaktstempel 8 vor der eigentlichen Montage beweglich in ihren Bohrungen des zweiten Hauptanschlusses 7 angeordnet sind. Um die Kontaktstempel nach der Montage fixieren zu können, ist zwischen der Bohrung und dem Kontaktstempel 8 nach dem ersten Ausführungsbeispiel eine Lotschicht 9 vorgesehen. Bei der Montage wird diese Lotschicht in einem Lötofen zum Schmelzen gebracht, so dass die Kontaktstempel fixiert werden. Eine selbsttätige Anpassung der Kontaktstempel-Länge an den individuellen Abstand zwischen dem zweiten Hauptanschluss 7 und den Halbleiterchips 2 erreicht man am einfachsten und vorzugsweise dadurch, dass das Halbleitermodul mit dem zweiten Hauptanschluss 7 nach oben verlötet wird. Die Kontaktstempel 8 fallen durch die Schwerkraft nach unten und kontaktieren die Chips. Zwischen den Chips 2 und den Kontaktstempeln 8 ist eine weitere Lotschicht 10, allenfalls mit dazwischengefügter Molybdänscheibe vorgesehen. Diese Lotschicht 10 wird im gleichen Arbeitsschritt wie die Lotschicht 9 im Lötofen verlötet. Um die Lage des ersten Hauptanschlusses gegenüber dem zweiten Hauptanschluss zu fixieren, wird die Anordnung mit einer Fixiervorrichtung umgeben, welche nach erfolgter Justierung eine präzise ausgerichtete Verbindung der Kontaktstempel 8 auf den Chips 2 während des Lötvorganges gewährleistet.

Ein wie oben beschrieben aufgebautes Leistungshalbleitermodul kann beispielsweise in ein von der GTO-Technologie bekanntes Druckkontaktgehäuse eingebaut werden. In diesem Fall ist es von Vorteil, wenn zwischen dem ersten und dem zweiten Hauptanschluss 6 und 7 ein Stützring 12 vorgesehen ist. Dieser entlastet die Lötstellen des Chips und die Kontaktstempel vom Druck. Ein allfällig vorgesehener Steueranschluss 11 wird dann am besten durch den Stützring 12 hindurchgeführt.

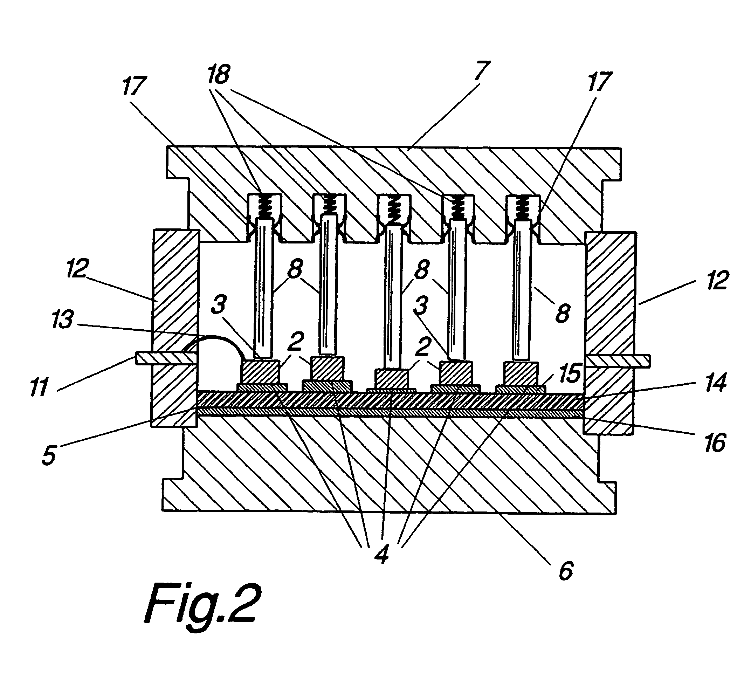

Figur 2 zeigt ein weiteres Ausführungsbeispiel eines erfindungsgemässen Leistungshalbleitermoduls. Der Aufbau entspricht im wesentlichen demjenigen nach Figur 1, und entsprechende Teile sind mit denselben Bezugszeichen versehen. Zur Fixierung und Einstellung der Länge der Kontaktstempel 8 sind hier aber nicht Lotschichten 9, sondern eine Kombination von Federn 18 und einem Gleitkontakt 17 vorgesehen. Die Federn sind in Bohrungen des zweiten Hauptanschlusses 7 angeordnet und beaufschlagen die Kontaktstempel 8 mit Druck. Auf diese Art wird die Länge der Kontaktstempel eingestellt. Zur Verbesserung des elektrischen Kontaktes zwischen den Kontaktstempeln 8 und dem zweiten Hauptanschluss 7 können ausserdem Gleitkontaktfedern 17 vorgesehen werden. Diese sind entlang der Bohrungswände zwischen den Kontaktstempeln und dem Hauptanschluss angeordnet. Die Federgleitkontakte können eine Vielzahl von Einzellamellen aufweisen.

Die mit Federdruck beaufschlagten Kontaktstempel 8 pressen nun auf die Chips 2. Im Gegensatz zum ersten Ausführungsbeispiel, in welchem zur Kontaktierung der Chips 2 eine Kombination von Lotschichten 10 und Mo-Plättchen 14 benötigt wird, reicht hier eine direkte Kontaktierung der Chips 2 mit den Kontaktstempeln 8 aus.

Mit dem erfindungsgemässen Leistungshalbleitermodul ist es auch möglich, verschiedene Typen von Modulen aufzubauen. Wird wie beispielsweise in der eingangs genannte US Patentschrift eine Kombination von IGBT-Chips und Dioden-Chips verwendet, so erhält man ein Schaltermodul, bei welchem die Antiparalleldiode integriert ist. Es jedoch auch denkbar, ganze Halb- oder Viertelbrückenmodule von Umrichtern in einem solchen Leistungshalbleitermodul zu integrieren oder einfach nur eine Hochleistungsdiode zu bauen. Die Erfindung ist im übrigen auch nicht auf IGBTs beschränkt, sondern wird für alle Arten von Leistungshalbleiterchips mit Vorteil eingesetzt. Obwohl die vorstehende Beschreibung von einem kreisrunden Querschnitt des Moduls ausgeht, ist die Erfindung nicht auf solche Querschnitte beschränkt.

Insgesamt ergibt sich mit der Erfindung ein Leistungshalbleitermodul, bei welchem die Anforderungen an die Planparallelität weniger hoch sind als beim Stand der Technik und welches somit einfacher hergestellt und aufgebaut werden kann.

### Bezeichnungsliste

- 1: Leistungshalbleitermodul
- 2: Halbleiterchips
- 3, 4: Elektroden
- 5: Grundplatte
- 6, 7: Hauptanschlüsse
- 8: Kontaktstempel
- 9, 10: Lotschicht
- 11: Steueranschluss
- 12: Stützring
- 13: Anschlussdraht
- 14: Molybdänplatte
- 15, 16: Lotschicht
- 17: Gleitkontakt
- 18: Feder

## Patentansprüche

1. Leistungshalbleitermodul (1) mit mindestens zwei Halbleiterchips (2), welche mindestens zwei Elektroden, nämlich eine erste (4) und eine zweite Hauptelektrode (3), aufweisen und welche Halbleiterchips (2) mit der ersten Hauptelektrode (4) auf einer Grundplatte (5) angebracht sind, und mit einem ersten und einem zweiten, mit den entsprechenden ersten und zweiten Hauptelektroden (4 bzw. 3) in elektrischer Verbindung stehenden Hauptanschluss (6 bzw. 7), wobei der erste Hauptanschluss (6) mit der Grundplatte (5) elektrisch zusammenwirkt und der zweite Hauptanschluss (7) Kontaktstempel (8) aufweist, welche mit der zweiten (3) Hauptelektrode jedes Halbleiterchips (2) elektrisch zusammenwirken, **dadurch gekennzeichnet, dass** der zweite Hauptanschluss (7) Bohrungen aufweist und die Kontaktstempel derart in den Bohrungen angeordnet sind, dass eine Lage jedes Kontaktstempels (8) entsprechend dem Abstand von jedem Halbleiterchip (2) zum zweiten Hauptanschluss (7) eingestellt ist und dass Mittel (9, 10; 17, 18) zur Fixierung der Lage jedes Kontaktstempels (8) vorgesehen sind.

2. Leistungshalbleitermodul nach Anspruch 1, **dadurch gekennzeichnet, dass** die Mittel zur Fixierung jedes Kontaktstempels (8) zwei Lotschichten (9, 10) umfassen, welche einerseits zwischen jedem Halbleiterchip (2) und jedem Kontaktstempel (8) und andererseits zwischen jedem Kontaktstempel (8) und einer den oder jeden Kontaktstempel aufnehmenden Bohrung im zweiten Hauptanschluss (7) vorgesehen sind.

3. Leistungshalbleitermodul nach Anspruch 1, **dadurch gekennzeichnet, dass** die Mittel zur Fixierung jedes Kontaktstempels (8) für jeden Kontaktstempel eine Feder (18) umfassen, welche in einer den oder jeden Kontaktstempel aufnehmenden Bohrung im zweiten Hauptanschluss (7) angeordnet ist.

4. Leistungshalbleitermodul nach Anspruch 3, **dadurch gekennzeichnet, dass** zwischen den Kontaktstempeln (8) und den Seitenwänden der Bohrungen elektrisch leitende Gleitfedern vorgesehen sind.

5. Verfahren zur Herstellung eines Leistungshalbleitermoduls mit mindestens zwei Halbleiterchips (2), **dadurch gekennzeichnet, dass**
- in einem ersten Schritt jeder Halbleiterchip (2) auf eine Grundplatte (5) gelötet wird;
- die Grundplatte (5) auf einen mit Bohrungen, in welche je ein Kontaktstempel (8) eingefügt ist, versehenen Hauptanschluss (7) aufgesetzt und bezüglich dieses Hauptanschlusses (7) fixiert wird, wobei einerseits zwischen jedem Kontaktstempel (8) und jedem Halbleiterchip (2) und andererseits in jeder Bohrung zwischen jedem Kontaktstempel (8) und dem Hauptanschluss (7) je eine Lotschicht (10 bzw. 9) eingelegt wird;
- das Halbleitermodul anschliessend mit dem Hauptanschluss (7) nach oben in einem Lötofen verlötet wird.

## Claims

1. Power semiconductor module (1) having at least two semiconductor chips (2), which have at least two electrodes, namely a first (4) and a second main electrode (3), and which semiconductor chips (2) are fitted to a baseplate (5) by the first main electrode (4), and having a first and a second main connection (6 and 7), which are electrically connected to the corresponding first and second main electrodes (4 and 3), the first main connection (6) electrically interacting with the baseplate (5) and the second main connection (7) having contact plungers (8), which electrically interact with the second (3) main electrode of each semiconductor chip (2), **characterized in that** the second main connection (7) has holes and the contact plungers are arranged in the holes in such a manner that a position of each contact plunger (8) is set in a manner corresponding to the distance between each semiconductor chip (2) and the second main connection (7), and **in that** means (9, 10; 17, 18) for fixing the position of each contact plunger (8) are provided.

2. Power semiconductor module according to Claim 1, **characterized in that** the means for fixing each contact plunger (8) comprise two solder layers (9, 10) which are provided, on the one hand, between each semiconductor chip (2) and each contact plunger (8) and, on the other hand, between each contact plunger (8) and a hole, accommodating the or each contact plunger, in the second main connection (7).

3. Power semiconductor module according to Claim 1, **characterized in that** the means for fixing each contact plunger (8) comprise a spring (18) for each contact plunger, which spring is arranged in a hole, accommodating the or each contact plunger, in the second main connection (7).

4. Power semiconductor module according to Claim 3, **characterized in that** electrically conductive sliding springs are provided between the contact plungers (8) and the side walls of the holes.

5. Method for the production of a power semiconductor module having at least two semiconductor chips (2), **characterized in that**
- in a first step each semiconductor chip (2) is soldered onto a baseplate (5);
- the baseplate (5) is placed onto a main connection (7), which is provided with holes into which a contact plunger (8) is inserted in each case, and is fixed with regard to this main connection (7), a respective solder layer (10 and 9) being inserted, on the one hand, between each contact plunger (8) and each semiconductor chip (2) and, on the other hand, in each hole between each contact plunger (8) and the main connection (7);
- the semiconductor module is subsequently soldered in a soldering furnace with the main connection (7) pointing upwards.

## Revendications

1. Module semi-conducteur de puissance (1) comprenant au moins deux puces à semi-conducteur (2), qui présentent au moins deux électrodes, à savoir une première (4) et une seconde électrodes principales (3), et lesquelles puces à semi-conducteur (2) sont placées avec la première électrode principale (4) sur une plaque de base (5), et avec un premier et un second branchements principaux (6 et 7) en liaison électrique avec les première et seconde électrodes principales (4 et 3) correspondantes, le premier branchement principal (6) coopérant électriquement avec la plaque de base (5) et le second branchement principal (7) présentant des poinçons de contact (8) qui coopèrent électriquement avec la seconde (3) électrode principale de chaque puce à semi-conducteur (2), **caractérisé en ce que** le second branchement principal présente des alésages et les poinçons de contact sont disposés dans les alésages de telle sorte qu'une position de chaque poinçon de contact (8) est réglée en fonction de la distance de chaque puce à semi-conducteur (2) au second branchement principal (7) et **en ce que** des moyens (9, 10, 17, 18) sont prévus pour la fixation de la position de chaque poinçon de contact (8).

2. Module semi-conducteur de puissance selon la revendication 1, **caractérisé en ce que** les moyens pour la fixation de chaque poinçon de contact (8) comprennent deux couches de brasage (9, 10), qui sont prévues d'une part entre chaque puce à semi-conducteur (2) et chaque poinçon de contact (8) et d'autre part entre chaque poinçon de contact (8) et un alésage recevant le ou chaque poinçon de contact dans le second branchement principal (7).

3. Module semi-conducteur de puissance selon la revendication 1, **caractérisé en ce que** les moyens pour la fixation de chaque poinçon de contact (8) comprennent pour chaque poinçon de contact un ressort (18) qui est disposé dans un alésage recevant le ou chaque poinçon de contact dans le second branchement principal (7).

4. Module semi-conducteur de puissance selon la revendication 3, **caractérisé en ce que** des ressorts à glissement électro-conducteurs sont prévus entre les poinçons de contact (8) et les parois latérales des alésages.

5. Procédé pour la fabrication d'un module semi-conducteur de puissance avec au moins deux puces à semi-conducteur (2), **caractérisé en ce que**
- chaque puce à semi-conducteur (2) est brasée sur une plaque de base (5) dans une première étape ;
- la plaque de base (5) est posée sur un branchement principal (7) doté d'alésages, dans chacun desquels est inséré un poinçon de contact (8), et est fixé par rapport à ce branchement principal (7), une couche de brasage (10 ou 9) étant insérée entre chaque poinçon de contact (8) et chaque puce à semi-conducteur (2) et d'autre part dans chaque alésage entre chaque poinçon de contact (8) et le branchement principal (7) ;
- le module semi-conducteur est brasé ensuite avec le branchement principal (7) vers le haut dans un four de brasage.
